# EUROPEAN PATENT SPECIFICATION

(11) **EP 1 523 784 B1**
(45) Date of publication and mention of the grant of the patent: **12.03.2008**
(21) Application number: 03732971.1
(22) Date of filing: 27.05.2003
(51) Int. Cl.: H01P 1/26, G01R 27/32

(54) **INTEGRATED CIRCUIT AND METHOD FOR MANUFACTURING SAME**
INTEGRIERTE SCHALTUNG UND VERFAHREN ZUR HERSTELLUNG
CIRCUIT INTEGRE ET PROCEDE DE FABRICATION DE CE CIRCUIT

(30) Priority: 06.06.2002 DE 10225042
(43) Date of publication of application: 20.04.2005
(73) Proprietor: Ericsson AB, Stockholm (SE)
(72) Inventor: KERN, Stefan, 68753 Waghäusel (DE)
(74) Representative: Parkinson, Neil Scott
(86) International application number: PCT/IB2003/002712
(87) International publication number: WO 2003/105186

(56) References cited:
- EP-A- 0 424 536
- EP-A- 0 622 840
- EP-A- 1 093 181
- WO-A-02/12916
- US-A1- 2002 000 894
- D'AGOSTINO S ET AL: "Design of high performance power distributed amplifier using Lange couplers" MICROWAVE SYMPOSIUM DIGEST, 1994., IEEE MTT-S INTERNATIONAL SAN DIEGO, CA, USA 23-27 MAY 1994, NEW YORK, NY, USA,IEEE, 23 May 1994 (1994-05-23), pages 281-284, XP010120537 ISBN: 0-7803-1778-5

## Description

The invention relates to an integrated circuit and to a method for manufacturing same, which are able to be used particularly for test passes when developing radio-frequency circuits (RF circuits) and also in RF circuit manufacture.

### Prior Art

Powerful communications technology and information technology currently plays a prominent role in all important areas of economy and science. A worldwide digital network which can be reached globally without restriction of location and allows individual access to information of all kinds is in the process of construction. Wireless (because they are mobile) communications systems are becoming increasingly important in this context.

Countless new services which use this technology, such as telemedicine and mobile data communication using laptops which are constantly connected to the network, are increasingly being used. Mobile information and communications systems will increase safety and mobility in road traffic, for example using vehicle anti-collision radar and satellite-aided navigation systems.

The result of development is that ever more powerful radio-frequency systems (RF systems) with a high bandwidth and increasing frequencies are becoming necessary. A few examples are mobile radio (0.9 and 1.8 - 1.9 GHz), satellite-controlled navigation systems (1.5 - 1.6; 12 and 14 GHz), WLANs (= Wireless Local Area Networks at 5.2 GHz), radio relay (for example 38 GHz for mobile radio base stations) and vehicle anti-collision radar at 77 GHz.

The constant introduction of new services which use radio-frequency technology (RF technology) therefore necessitates higher and higher frequencies, since the frequency bands used to date have in the meantime become very densely occupied. As the frequency increases, however, the wavelength becomes shorter and shorter. As soon as the dimensions of a circuit or the elements thereof reach the order of magnitude of this wavelength, propagation time effects, in particular, need to be taken into account when designing circuits. For this reason, attempts are being made to make the circuit dimensions smaller and smaller. This reduction in size is possible using monolithically integrated microwave circuits (MMIC = Microwave Monolithic Integrated Circuits). With this technology, all the circuit elements required for manufacture are attached to a semiconductor material using thin-film technology in a plurality of processes. Since no hybrid elements, as in the case of the integrated microwave circuits (MIC), are used, further miniaturization is possible. As compared with MICs, MMICs afford other advantages too. Thus, an MMIC circuit is much more reliable than an MIC circuit, since there are no subsequently attached components which could become detached. MMICs have smaller production variations and can therefore be reproduced better.

A line technology established to date for MMICs is the microstrip line (microstrip). This line has an earth metallization on the back. The lines and components are attached on the top.

During MMIC development, the individual parts of a circuit, such as amplifiers, mixers, couplers or power splitters, are normally tested individually on their own. If such a radio-frequency circuit (or RF circuit) needs to be measured, then all the ports need to have been connected to the measurement device, such as a radio-frequency probe or RF probe, or else to a termination, the unused ports needing to be terminated on a controlled reflection-free basis in radio-frequency technology. If these controlled reflection-free terminations have not already been implemented on the chip, however, it is difficult - particularly in the range of millimetre wavelengths - to terminate unterminated ports subsequently in a controlled fashion. In such a case in which the ports are terminated subsequently, off-chip termination is referred to. Terminations which have already been implemented on the chip are referred to as on-chip terminations. Owing to the aforementioned drawbacks which arise when using off-chip terminations, it is often preferred for the controlled, reflection-free terminations to be integrated on the chip previously, even though this relinquishes the flexibility which the off-chip terminations would allow. This is a drawback of the on-chip terminations terminated with the required quality on a controlled reflection-free basis, because when using the on-chip terminations, that is to say when a permanent, integrated termination is used for the ports which are unused during measurement, every port termination which is required for a measurement needs to have been implemented on the chip. This means that the same circuit needs to be placed on the test chip a number of times, because it requires different port terminations.

Although it is also possible to use a type of electronic on-chip switches, this option is rarely used because these non-linear switches entail another drawback in that a matched, reflection-free termination is likewise difficult to produce when they are used, and also distortions are caused.

We are aware of United States Patent Application Publication number US2002/0000894, which discloses detachable terminations on the end of transmission lines.

We are also aware of European Patent Application publication number EP 0 622 840, which discloses forming resistors by burning away a substrate using a laser.

Finally, we are aware of PCT Patent Application Publication number WO02/12916, which discloses a circuit having several MMIC chips, and removable terminations provided off-chip, connected to non-integrated circulators. It forms the precharacterising portion of claims 1 and 11.

### Advantages of the invention

The invention is therefore based on the object of developing an integrated circuit and a method for manufacturing same which overcome the aforementioned drawbacks, specifically with respect to material consumption and flexibility in the case of test passes for chip development and for chip manufacture, and which at the same time provide the respective matched reflection-free terminations which are required.

The invention achieves this object by virtue of the features in the characterizing part of Claims 1 and 11 in interaction with the features in the precharacterizing part. Expedient refinements of the invention are contained in the subclaims.

A particular advantage of the integrated circuit is that at least some of the ports and/or microstrip lines in the integrated circuit have a removable, reflection-free termination which is integrated on the chip.

A method for manufacturing an integrated circuit involves an integrated circuit being produced in a first step, with at least some of the ports and/or microstrip lines in the integrated circuit being provided with a removable, reflection-free termination which is integrated on the chip, and in a second step this termination being removed from a prescribable selection of the ports and/or microstrip lines provided with the removable, reflection-free termination which is integrated on the chip.

Another advantage of the invention is that the integrated circuit is in the form of an MMIC circuit. It is likewise found to be advantageous that the integrated circuit is in the form of a radio-frequency circuit.

One preferred embodiment of the inventive integrated circuit is that the integrated circuit is in the form of a test circuit.

It is also found to be advantageous that the ports in the integrated circuit are in the form of coplanar line ports.

Another advantage of the inventive integrated circuit is that the integrated circuit has at least one amplifier and/or one mixer and/or one coupler and/or one power splitter.

In one preferred embodiment of the invention, all the ports and/or microstrip lines in the integrated circuit have a removable, reflection-free termination which is integrated on the chip.

It is likewise found to be an advantage of the inventive circuit that input Lange couplers arranged on a chip have at least one port having a removable, reflection-free termination which is integrated on the chip.

Another advantage is that the removable, reflection-free terminations which are integrated on the chip are in the form of absorbing resistors.

It is also found to be advantageous that the removable, reflection-free terminations which are integrated on the chip are arranged symmetrically with respect to radio-frequency signal lines.

One preferred embodiment of the inventive method involves, in the first step of the method according to Claim 11, all the ports and/or microstrip lines in the integrated circuit being provided with a removable, reflection-free termination which is integrated on the chip.

It is likewise found to be advantageous that absorbing resistors are used for the removable, reflection-free terminations which are integrated on the chip.

Another advantage of the inventive method is that the position and dimensions of removable, reflection-free terminations which are integrated on the chip are optimized for a reflection-free termination.

It can also be regarded as advantageous that the removable, reflection-free terminations which are integrated on the chip are arranged symmetrically with respect to radio-frequency signal lines.

Of advantage is a procedure in which the removable, reflection-free terminations which are integrated on the chip are removed by a laser.

It is also advantageous that the ports and/or microstrip lines to be opened are selected in the second step of the method according to Claim 11 on the basis of the requirements of the measurement arrangements used for making contact with the radio-frequency connections.

In one preferred refinement of the inventive method, following removal of the removable, reflection-free terminations which are integrated on the chip, the ports and/or microstrip lines which are now open in the integrated circuit are connected to a measurement device. In this case, it is found to be advantageous that a radio-frequency connection is used as the connection to the measurement device.

In addition, in one preferred refinement of the inventive method, the measurement device is used to test individual parts of the integrated circuit, such as amplifiers, mixers, couplers and/or power splitters, individually on their own.

It is likewise found to be an advantage that the removal of removable, reflection-free terminations which are integrated on the chip stipulates properties of the integrated circuit.

In particular, in one preferred refinement of the inventive method, the removal of removable, reflection-free terminations which are integrated on the chip stipulates the suppressed sideband of a mixer.

The invention provides a termination for radio-frequency ports (RF ports) which is integrated on the chip and is suitable for making contact using a radio-frequency probe (RF probe). This makes it possible to save a large area on the "tile". The tile refers to the (limited) area which is available for designing new chips and can be used for test passes during development work.

Whereas n*(n-1)/2 test objects were conventionally required for an n-port device, for example, precisely one test object is needed when employing the invention.

The invention can also be used to provide alternative radio-frequency ports on an MMIC circuit which are able to be opened selectively according to requirements while the rest of the ports are kept terminated. This can be used advantageously not just when developing radio-frequency circuits but also when manufacturing these circuits, for example in order to select the suppressed sideband of a sideband mixer by virtue of one of the two ports of the input Lange coupler being connected while the other is kept terminated.

Advantageous refinements of the invention can be found in the features cited in the subclaims.

### Drawings

The invention will be explained in more detail below using an exemplary embodiment illustrated at least in part in the Figures, in which:
Figure 1 shows a design for a conventional pad for radio frequency probes (RF probe pad);
Figure 2 shows a design for an RF probe pad provided with removable terminations;
Figure 3 shows an attenuation curve to illustrate the transmission when the port is terminated for the purpose of checking the quality of the termination, and
Figure 4 shows an attenuation curve to illustrate the transmission when the termination has been removed by "lasering away".

### Description of the exemplary embodiment

The exemplary embodiment of the invention will be illustrated below using the design of a coupler in a radio frequency circuit. However, the invention can be used suitably not just for this specific example, but rather generally during chip development and also during manufacture, for example in order to select the top or bottom sideband for an integrated mixer.

To design new chips, there is generally only a limited area available - the "tile" or "recticle". The tile or recticle corresponds to the photomask, on which a plurality of different chip designs can be held. Of this mask, a plurality are accommodated on the wafer, however. For this reason, a large number of identical chips are ultimately obtained from this design. To date, it has been necessary to accommodate a respective coupler on the tile for each combination of the coupler's measurement ports which is to be rated. With the inventive method, precisely one embodiment of the coupler is needed. This then later likewise yields a large number of copies whose ports can be opened differently, according to the requirements of the respective measurement. To date, for an n-coupler, if all combinations of ports (that is to say n*(n-1)/2) needed to be rated, a special coupler design would have been needed for all these n*(n-1)/2 variants, which then also provide a large number of copies - generally more than are needed. Surface area is thus saved on the tile. This naturally also means that the end effect is that the corresponding chip area is saved.

To avoid the aforementioned drawbacks, particularly the need to implement the same circuit on the (test) chip a plurality of times, the invention proposes a removable, reflection-free termination for the ports which is integrated on the chip.

The inventive removable termination can serve as a termination, by way of example, for microstrip lines 1 and/or coplanar line ports which can be opened in order to permit a radio-frequency connection to the port. This means that a single circuit whose ports are respectively equipped with a removable, reflection-free termination which is integrated on the chip can be used for any measurement arrangements. Thus, the inventive controlled termination suitable for making contact with RF connections reduces the area requirement on the tile, and hence ultimately also the chip area requirement, when carrying out test passes for development purposes. (In chip production, the chip area is limited, whereas a wafer normally yields a plurality of identical chips). Generally, it is useful to have alternative RF ports available on an MMIC circuit in order to open them selectively, according to the requirements of the respective measurement, while the rest of the ports are kept terminated. Likewise - as shown above using the example of sideband suppression for a sideband mixer - there are applications in chip manufacture where the use of the invention is found to be advantageous, however.

In order to be able to open a port for the purpose of making radio-frequency contact (RF probing), the inventive termination needs to be removed. This termination replaces the aforementioned electronic, non-linear switches and avoids the drawbacks thereof. In the case of the inventive removable, reflection-free terminations which are integrated on the chip, the absorbing resistors 2 are cut away mechanically by a laser, so that finally a normal configuration is left for radio-frequency probing. When the resistor 2 has been removed by virtue of the resistor coating having been "lasered away", such an RF port is open for contact to be made by a measurement arrangement.

For terminations of this kind, it is important for the RF port to be terminated in a really controlled manner when the termination has been added, while virtually loss-free transmission needs to be ensured when the resistor 2 has been removed. The most difficult problem needing to be solved in this context is that of converting a normal radio-frequency contact into a good absorber merely by attaching a resistor 2 which terminates in a controlled manner.

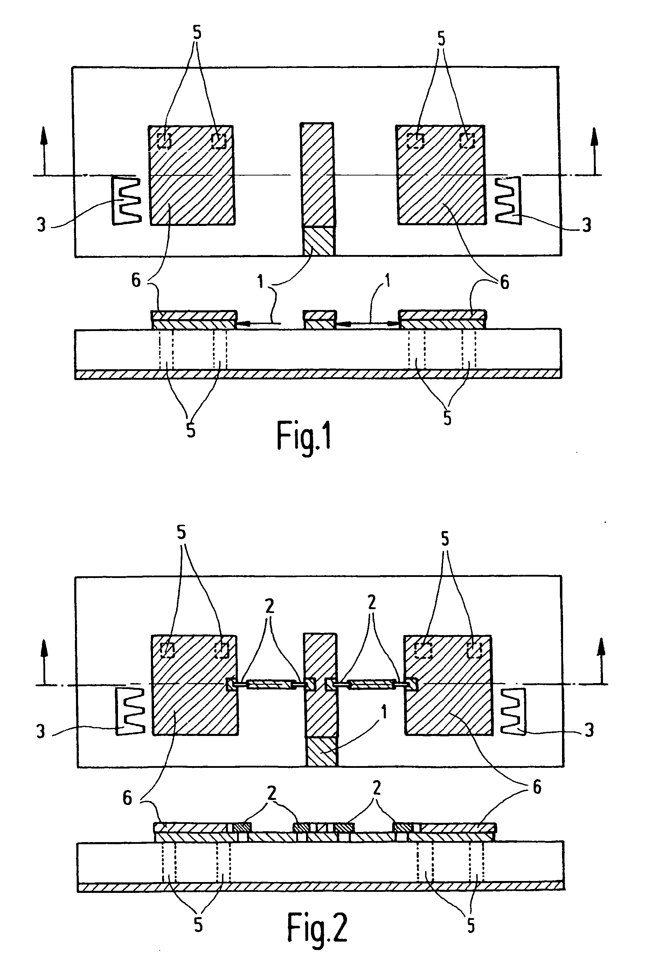

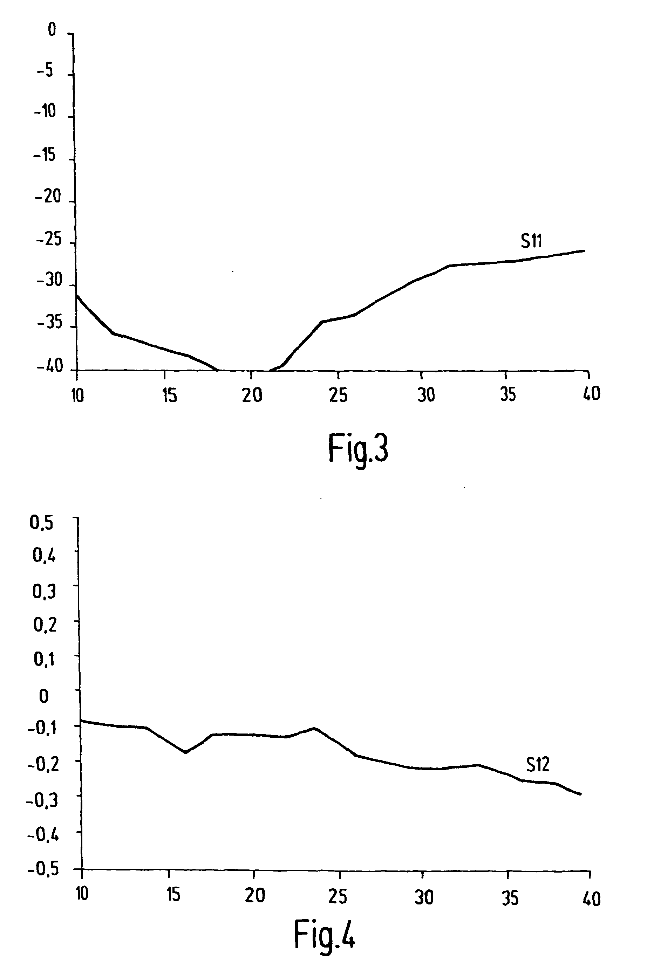

Figure 2 shows an example of such an absorber. In this case, the MMIC substrate is shown in plan view; the underside of the MMIC substrate has been metallized and serves as "ground". In addition, Figure 2 shows the position markers 3 which are normal for a connection for radio-frequency probes but can also be dispensed with. The pads for making RF contact 4 are connected to the underlying ground through the via holes 5. While the metal form of the pads for making RF contact 4 is identical to those for a conventional connection for making RF contact 4 (cf. Figure 1), two resistors 2 are arranged symmetrically with respect to the RF signal line. In this case, the position and dimensions of the resistors 2 have been optimized in order to produce the controlled termination, as can be seen in Figure 3. The transmission when the termination has been removed is shown in Figure 4. In this case, a small amount of attenuation arises which is typically 0.1 dB to 0.3 dB and is caused as a result of a slight conductivity in the substrate material when the resistors 2 have been removed by a laser. For the purposes of the measurements which are to be performed, this RF connection is sufficient, however.

The typical measurement for a multiport proceeds as follows:

For each tile - that is to say on the limited design area - there is a coupler design, for example, where all the ports have been terminated using the inventive removable, reflection-free termination which is integrated on the chip. However, many, for example m, chips are obtained with this one design, in which case the conventional method would be used to obtain m times n*(n-1)/2 couplers. This is in contrast to what is now only m copies.

For every combination of measurement ports which is to be rated, the corresponding inventive terminations are removed from at least one copy in each case, so that the necessary n*(n-1)/2 measurement objects are obtained as a result.

The formula n*(n-1)/2 is obtained as follows:

### Example: 4-port coupler:

For this, six combinations are required:

| | | |
|---|---|---|
| Port 1 | <---> | Port 2 |
| Port 1 | <---> | Port 3 |
| Port 1 | <---> | Port 4 |
| Port 2 | <---> | Port 3 |
| Port 2 | <---> | Port 4 |
| Port 3 | <---> | Port 4 |

With a large number of real couplers, this number is reduced by symmetries, however, but two designs would nevertheless be needed at least.

## Claims

1. Monolithic microwave integrated circuit having at least one microstrip line (1) and at least one port, **characterized in that** at least some of the ports and/or microstrip lines (1) in the integrated circuit have a removable, reflection-free termination (2) which is integrated on the chip.

2. Integrated circuit according to claim 1, **characterized in that** the integrated circuit is in the form of a test circuit.

3. Integrated circuit according to one of the preceding claims, **characterized in that** the ports in the integrated circuit are in the form of coplanar line ports.

4. Integrated circuit according to one of the preceding claims, **characterized in that** the integrated circuit has at least
- one amplifier and/or
- one mixer and/or
- one coupler and/or
- one power splitter

5. Integrated circuit according to one of the preceding claims, **characterized in that** all the ports and/or microstrip lines (1) in the integrated circuit have a removable, reflection-free termination (2) which is integrated on the chip.

6. Integrated circuit according to Claim 4, **characterized in that** input Lange couplers arranged on a chip have at least one port having a removable, reflection-free termination (2) which is integrated on the chip.

7. Integrated circuit according to one of the preceding claims, **characterized in that** the removable, reflection-free terminations which are integrated on the chip are in the form of absorbing resistors (2).

8. Integrated circuit according to one of the preceding claims, **characterized in that** the removable, reflection-free terminations (2) which are integrated on the chip are arranged symmetrically with respect to radio-frequency signal lines.

9. Method for manufacturing a monolithic microwave integrated circuit, **characterized in that** an integrated circuit is produced in a first step, with at least some of the ports and/or microstrip lines (1) in the integrated circuit being provided with a removable, reflection-free termination (2) which is integrated on the chip, and in a second step this termination is removed from a prescribable selection of the ports and/or microstrip lines (1) provided with the removable, reflection-free termination which is integrated on the chip.

10. Method according to Claim 9, **characterized in that**, in the first step of the method according to Claim 11, all the ports and/or microstrip lines (1) in the integrated circuit are provided with a removable, reflection-free termination (2) which is integrated on the chip.

11. Method according to one of Claims 9 or 10, **characterized in that** absorbing resistors (2) are used for the removable, reflection-free terminations which are integrated on the chip.

12. Method according to one of Claims 9 to 11, **characterized in that** the position and dimensions of removable, reflection-free terminations (2) which are integrated on the chip are optimized for a reflection-free termination.

13. Method according to one of Claims 9 to 12, **characterized in that** the removable, reflection-free terminations (2) which are integrated on the chip are arranged symmetrically with respect to radio-frequency signal lines.

14. Method according to one of Claims 9 to 13, **characterized in that** the removable, reflection-free terminations which are integrated on the chip are removed by a laser.

15. Method according to one of Claims 9 to 14, **characterized in that** the ports and/or microstrip lines (1) to be opened are selected in the second step of the method according to Claim 11 on the basis of the requirements of the measurement arrangements used for making contact with the radio-frequency connections (4).

16. Method according to one of Claims 9 to 15, **characterized in that**, following removal of the removable, reflection-free terminations (2) which are integrated on the chip, the ports and/or microstrip lines (1) which are now open in the integrated circuit are connected to a measurement device.

17. Method according to one of Claims 9 to 16, **characterized in that** a radio-frequency connection is used as the connection to the measurement device.

18. Method according to one of Claims 9 to 17, **characterized in that** the measurement device is used to test individual parts of the integrated circuit, such as amplifiers, mixers, couplers and/or power splitters, individually on their own.

19. Method according to one of Claims 9 to 18, **characterized in that** the removal of removable, reflection-free terminations (2) which are integrated on the chip stipulates properties of the integrated circuit.

20. Method according to one of Claims 9 to 19, **characterized in that** the removal of removable, reflection-free terminations (2) which are integrated on the chip stipulates the suppressed sideband of a mixer.

## Patentansprüche

1. Monolithische integrierte Mikrowellenschaltung mit wenigstens einer Mikrostreifenleitung (1) und wenigstens einem Tor, **dadurch gekennzeichnet, dass** wenigstens einige der Tore und/oder Mikrostreifenleitungen (1) in der integrierten Schaltung einen entfernbaren, reflexionsfreien Abschuss (2) aufweisen, der auf dem Chip integriert ist.

2. Integrierte Schaltung nach Anspruch 1, **dadurch gekennzeichnet, dass** die integrierte Schaltung in Form einer Testschaltung ist.

3. Integrierte Schaltung nach einem der vorhergehenden Ansprüche, **dadurch gekennzeichnet, dass** die Tore in der integrierten Schaltung in Form von koplanaren Leitungstoren sind.

4. Integrierte Schaltung nach einem der vorhergehenden Ansprüche, **dadurch gekennzeichnet, dass** die integrierte Schaltung wenigstens aufweist:
- einen Verstärker und/oder
- einen Mischer und/oder
- einen Koppler und/oder
- einen Leistungsteiler.

5. Integrierte Schaltung nach einem der vorhergehenden Ansprüche, **dadurch gekennzeichnet, dass** alle Tore und/oder Mikrostreifenleitungen (1) in der integrierten Schaltung einen entfernbaren, reflexionsfreien Abschluss (2) aufweisen, der auf dem Chip integriert ist.

6. Integrierte Schaltung nach Anspruch 4, **dadurch gekennzeichnet, dass** Eingangs-Lange-Koppler, die auf einem Chip angeordnet sind, wenigstens ein Tor mit einem entfernbaren, reflexionsfreien Abschluss (2) aufweisen, der auf dem Chip integriert ist.

7. Integrierte Schaltung nach einem der vorhergehenden Ansprüche, **dadurch gekennzeichnet, dass** die entfernbaren, reflexionsfreien Abschlüsse, die auf dem Chip integriert sind, in Form von absorbierenden Widerständen (2) sind.

8. Integrierte Schaltung nach einem der vorhergehenden Ansprüche, **dadurch gekennzeichnet, dass** die entfernbaren, reflexionsfreien Abschlüsse (2), die auf dem Chip integriert sind, symmetrisch in Bezug auf Hochfrequenzsignalleitungen angeordnet sind.

9. Verfahren zur Herstellung einer monolithischen integrierten Mikrowellenschaltung, **dadurch gekennzeichnet, dass** in einem ersten Schritt eine integrierte Schaltung hergestellt wird, wobei wenigstens einige der Tore und/oder Mikrostreifenleitungen (1) in der integrierten Schaltung mit einem entfernbaren, reflexionsfreien Abschluss (2), der auf dem Chip integriert ist, versehen werden, und in einem zweiten Schritt dieser Abschluss von einer vorgebbaren Auswahl der Tore und/oder Mikrostreifenleitungen (1), die mit dem auf dem Chip integrierten entfernbaren, reflexionsfreien Abschluss versehen sind, entfernt wird.

10. Verfahren nach Anspruch 9, **dadurch gekennzeichnet, dass** im ersten Schritt des Verfahrens nach Anspruch 11 alle Tore und/oder Mikrostreifenleitungen (1) in der integrierten Schaltung mit einem entfernbaren, reflexionsfreien Abschluss (2), der auf dem Chip integriert ist, versehen werden.

11. Verfahren nach einem der Ansprüche 9 oder 10, **dadurch gekennzeichnet, dass** absorbierende Widerstände (2) für die entfernbaren, reflexionsfreien Abschlüsse, die auf dem Chip integriert sind, verwendet werden.

12. Verfahren nach einem der Ansprüche 9 bis 11, **dadurch gekennzeichnet, dass** die Position und die Abmessungen von entfernbaren, reflexionsfreien Abschlüssen (2), die auf dem Chip integriert sind, für einen reflexionsfreien Abschluss optimiert werden.

13. Verfahren nach einem der Ansprüche 9 bis 12, **dadurch gekennzeichnet, dass** die entfernbaren, reflexionsfreien Abschlüsse (2), die auf dem Chip integriert sind, symmetrisch in Bezug auf Hochfrequenzsignalleitungen angeordnet werden.

14. Verfahren nach einem der Ansprüche 9 bis 13, **dadurch gekennzeichnet, dass** die entfernbaren, reflexionsfreien Abschlüsse, die auf dem Chip integriert sind, durch einen Laser entfernt werden.

15. Verfahren nach einem der Ansprüche 9 bis 14, **dadurch gekennzeichnet, dass** die zu öffnenden Tore und/oder Mikrostreifenleitungen (1) im zweiten Schritt des Verfahrens nach Anspruch 11 auf der Basis der Anforderungen der Messanordnungen, die zur Herstellung eines Kontakts mit den Hochfrequenzverbindungen (4) verwendet werden, ausgewählt werden.

16. Verfahren nach einem der Ansprüche 9 bis 15, **dadurch gekennzeichnet, dass** nach der Entfernung der entfernbaren, reflexionsfreien Abschlüsse (2), die auf dem Chip integriert sind, die nun offenen Tore und/oder Mikrostreifenleitungen (1) in der integrierten Schaltung mit einer Messvorrichtung verbunden werden.

17. Verfahren nach einem der Ansprüche 9 bis 16, **dadurch gekennzeichnet, dass** eine Hochfrequenzverbindung als die Verbindung mit der Messvorrichtung verwendet wird.

18. Verfahren nach einem der Ansprüche 9 bis 17, **dadurch gekennzeichnet, dass** die Messvorrichtung verwendet wird, um einzelne Teile der integrierten Schaltung, wie beispielsweise Verstärker, Mischer, Koppler und/oder Leistungsteiler, für sich allein einzeln zu testen.

19. Verfahren nach einem der Ansprüche 9 bis 18, **dadurch gekennzeichnet, dass** die Entfernung von entfernbaren, reflexionsfreien Abschlüssen (2), die auf dem Chip integriert sind, Eigenschaften der integrierten Schaltung festlegt.

20. Verfahren nach einem der Ansprüche 9 bis 19, **dadurch gekennzeichnet, dass** die Entfernung von entfernbaren, reflexionsfreien Abschlüssen (2), die auf dem Chip integriert sind, das unterdrückte Seitenband eines Mischers festlegt.

## Revendications

1. Circuit intégré micro-ondes monolithique ayant au moins une ligne microruban (1) et au moins un port, **caractérisé en ce que** au moins certains des ports et/ou lignes microruban (1) dans le circuit intégré ont une terminaison (2) amovible, exempte de réflexion qui est intégrée sur la puce.

2. Circuit intégré selon la revendication 1, **caractérisé en ce que** le circuit intégré prend la forme d'un circuit de test.

3. Circuit intégré selon une des revendications précédentes, **caractérisé en ce que** les ports dans le circuit intégré prennent la forme de ports de ligne coplanaire.

4. Circuit intégré selon une des revendications précédentes, **caractérisé en ce que** le circuit intégré comporte au moins:
- un amplificateur et/ou
- un mélangeur et/ou
- un coupleur et/ou
- un diviseur de puissance.

5. Circuit intégré selon une des revendications précédentes, **caractérisé en ce que** tous les ports et/ou lignes microruban (1) dans le circuit intégré ont une terminaison (2) amovible, exempte de réflexion qui est intégrée sur la puce.

6. Circuit intégré selon la revendication 4, **caractérisé en ce que** des coupleurs de Lange d'entrée agencés sur une puce comportent au moins un port ayant une terminaison (2) amovible, exempte de réflexion qui est intégrée sur la puce.

7. Circuit intégré selon une des revendications précédentes, **caractérisé en ce que** les terminaisons amovibles, exemptes de réflexion qui sont intégrées sur la puce prennent la forme de résistances absorbantes (2).

8. Circuit intégré selon une des revendications précédentes, **caractérisé en ce que** les terminaisons (2) amovibles, exemptes de réflexion qui sont intégrées sur la puce sont agencées symétriquement par rapport aux lignes de signaux de radiofréquence.

9. Procédé de fabrication d'un circuit intégré micro-ondes monolithique, **caractérisé en ce que** un circuit intégré est produit dans une première étape, au moins certains des ports et/ou lignes microruban (1) dans le circuit intégré étant pourvus d'une terminaison (2) amovible, exempte de réflexion qui est intégrée sur la puce, et dans une seconde étape cette terminaison est éliminée d'une sélection prescriptible des ports et/ou lignes microruban (1) pourvus de la terminaison amovible, exempte de réflexion qui est intégrée sur la puce.

10. Procédé selon la revendication 9, **caractérisé en ce que**, dans la première étape du procédé selon la revendication 11, tous les ports et/ou lignes microruban (1) dans le circuit intégré sont pourvus d'une terminaison (2) amovible, exempte de réflexion qui est intégrée sur la puce.

11. Procédé selon une des revendications 9 à 10, **caractérisé en ce que** les résistances absorbantes (2) sont utilisées pour les terminaisons amovibles, exemptes de réflexion qui sont intégrées sur la puce.

12. Procédé selon une des revendications 9 à 11, **caractérisé en ce que** la position et les dimensions des terminaisons (2) amovibles, exemptes de réflexion qui sont intégrées sur la puce sont optimisées pour une terminaison exempte de réflexion.

13. Procédé selon une des revendications 9 à 12, **caractérisé en ce que** les terminaisons (2) amovibles, exemptes de réflexion qui sont intégrées sur la puce sont agencées symétriquement par rapport aux lignes de signaux de radiofréquence.

14. Procédé selon une des revendications 9 à 13, **caractérisé en ce que** les terminaisons amovibles, exemptes de réflexion qui sont intégrées sur la puce sont éliminées par un laser.

15. Procédé selon une des revendications 9 à 14, **caractérisé en ce que** les ports et/ou lignes microruban (1) qui doivent être ouverts sont sélectionnés dans la seconde étape du procédé selon la revendication 11 sur la base des exigences des dispositifs de mesure utilisés pour réaliser un contact avec les connexions de radiofréquence (4).

16. Procédé selon une des revendications 9 à 15, **caractérisé en ce que**, à la suite de l'élimination des terminaisons (2) amovibles, exemptes de réflexion qui sont intégrées sur la puce, les ports et/ou lignes microruban (1) qui sont à présent ouverts dans le circuit intégré sont connectés à un dispositif de mesure.

17. Procédé selon une des revendications 9 à 16, **caractérisé en ce que** une connexion de radiofréquence est utilisée en tant que connexion au dispositif de mesure.

18. Procédé selon une des revendications 9 à 17, **caractérisé en ce que** le dispositif de mesure est utilisé pour tester des parties individuelles du circuit intégré, telles que des amplificateurs, mélangeurs, coupleurs et/ou diviseurs de puissance, individuellement et isolément.

19. Procédé selon une des revendications 9 à 18, **caractérisé en ce que** l'élimination des terminaisons (2) amovibles, exemptes de réflexion qui sont intégrées sur la puce stipule des propriétés du circuit intégré.

20. Procédé selon une des revendications 9 à 19, **caractérisé en ce que** l'élimination des terminaisons (2) amovibles, exemptes de réflexion qui sont intégrées sur la puce stipule la bande latérale supprimée d'un mélangeur.
